# EUROPÄISCHE PATENTSCHRIFT

(11) **EP 3 898 151 B1**
(45) Veröffentlichungstag und Bekanntmachung des Hinweises auf die Patenterteilung: **20.09.2023**
(21) Anmeldenummer: 19828615.5
(22) Anmeldetag: 12.12.2019
(51) Int. Cl.: B28D 5/00, B28D 5/04, B23D 59/00

(54) **VERFAHREN ZUR HERSTELLUNG VON HALBLEITERSCHEIBEN MITTELS EINER DRAHTSÄGE**
METHOD FOR PRODUCING SEMICONDUCTOR WAFERS USING A WIRE SAW
PROCÉDÉ DE FABRICATION DE TRANCHES DE SEMI-CONDUCTEUR AU MOYEN D'UNE SCIE À FIL

(30) Priorität: 17.12.2018 DE 102018221921
(43) Veröffentlichungstag der Anmeldung: 27.10.2021
(73) Patentinhaber: Siltronic AG, 81677 München (DE)
(72) Erfinder: BEYER, Axel, 80538 München (DE); FRINTERT, Carl, 84453 Mühldorf am Inn (DE); WIESNER, Peter, 84367 Reut (DE); GMACH, Wolfgang, 84547 Emmerting (DE); KREUZEDER, Robert, 84329 Wurmannsquick (DE)
(74) Vertreter: Staudacher, Wolfgang
(86) Internationale Anmeldenummer: PCT/EP2019/084799
(87) Internationale Veröffentlichungsnummer: WO 2020/126784

(56) Entgegenhaltungen:
- JP-A- H11 165 251

## Beschreibung

Gegenstand der Erfindung ist ein Verfahren, gemäß dem Oberbegriff des Patentanspruchs 1, zur Herstellung von Halbleiterscheiben aus einem Werkstück durch Bearbeiten des Werkstücks mittels einer Drahtsäge.

### Stand der Technik / Probleme

Aus JP 11 165 251 A ist ein Verfahren, gemäß dem Oberbegriff des Patentanspruchs 1, zur Herstellung von Scheiben (wafers) aus einem Werkstück (ingot) mittels einer Drahtsäge bekannt, das folgende Schritte umfasst: das Detektieren des Betrags und der Richtung der Auslenkung von Drähten eines Drahtfelds der Drahtsäge entlang einer axialen Richtung des Werkstücks und, abhängig vom Ergebnis der Detektion, das Herbeiführen einer Ausgleichsbewegung des Werkstücks zur Korrektur der Auslenkung der Drähte.

Aus JP 2000 15 552 A ist ein ähnliches Verfahren bekannt, das folgende Schritte umfasst: zum Zeitpunkt einer Umkehr der Laufrichtung der Drähte das Herbeiführen einer Ausgleichsbewegung des Werkstücks entlang einer axialen Richtung des Werkstücks im Umfang eines vorausbestimmten Betrags, wobei der Betrag derart vorausbestimmt ist, dass die Auslenkung der Drähte zum Zeitpunkt der Umkehr der Laufrichtung der Drähte korrigiert wird.

Aus US 5 875 770 ist ein ähnliches Verfahren bekannt, das folgende Schritte umfasst: das Detektieren einer warp-Kurve von Scheiben vor der Bearbeitung des Werkstücks und das Herbeiführen einer Ausgleichsbewegung des Werkstücks entlang einer axialen Richtung des Werkstücks in einem Umfang, dass Scheiben mit reduziertem warp entstehen.

Ungeachtet dieser zur Verfügung stehenden Lösungen besteht weiterhin Bedarf an einer Verbesserung des Verfahrens zur Herstellung von Halbleiterscheiben aus einem Werkstück mittels einer Drahtsäge. Insbesondere ist zu berücksichtigen, dass Werkstück und Drähte beispielsweise in Folge von Wärmeausdehnung des Werkstücks und/oder der Drahtführungsrollen Relativbewegungen ausführen, was sich nachteilig auf die lokale Ebenheit der Halbleiterscheiben auswirkt.

Notwendig ist insbesondere eine Verbesserung des Verfahrens, damit Halbleiterscheiben zugänglich werden, deren Ebenheit, insbesondere hinsichtlich warp und Nanotopographie, besser ist, als diejenige von Scheiben, die in bekannter Weise hergestellt werden.

Aus der beschriebenen Problematik ergab sich die Aufgabenstellung der Erfindung.

Die Aufgabe der Erfindung wird gelöst durch ein Verfahren zur Herstellung von Halbleiterscheiben aus einem Werkstück durch Bearbeiten des Werkstücks mittels einer Drahtsäge, umfassend
das Zustellen des Werkstücks durch eine Anordnung von Drähten, die zwischen Drahtführungsrollen gespannt sind und sich in eine Laufrichtung bewegen;
das Erzeugen von Schnittspalten beim Eingriff der Drähte in das Werkstück;
das Ermitteln einer Fehllage der Schnittspalte; und
das Herbeiführen einer Ausgleichsbewegung des Werkstücks in Abhängigkeit der ermittelten Fehllage entlang einer Längsachse des Werkstücks während des Zustellens des Werkstücks durch die Anordnung von Drähten.

Eine vom Werkstück abgetrennte Halbleiterscheibe hat eine obere und eine untere Seitenfläche und eine zwischen beiden verlaufende Kante. Üblicherweise wird angestrebt, dass die obere und untere Seitenfläche nach dem Abtrennen vom Werkstück möglichst eben sind und einen möglichst gleichmäßigen Abstand zueinander haben. Je besser die Ebenheit der Seitenflächen und die Gleichmäßigkeit der Dicke der Halbleiterscheibe anfänglich sind, desto eher gelingt es und desto geringer wird der Aufwand, die Halbleiterscheibe durch nachfolgende Schritte wie Läppen und/oder Schleifen, Ätzen, Polieren und gegebenenfalls Beschichten in ein Zielprodukt zu veredeln, das den strengen Anforderungen der Industrie genügt, die die Halbleiterscheibe zu elektronischen Bauelementen weiterverarbeitet. Die obere Seitenfläche wird auch als Vorderseite der Halbleiterscheibe bezeichnet und ist in der Regel diejenige Fläche, auf der oder in die im Zuge einer Weiterverarbeitung der Halbleiterscheibe beabsichtigt ist, Strukturen elektronischer Bauelemente unterzubringen.

Die vorliegende Erfindung verfolgt das Ziel, beim Bearbeiten des Werkstücks mittels einer Drahtsäge dafür zu sorgen, dass Schnittspalte im Werkstück entstehen, deren Lage möglichst geringfügig von einer als ideal angesehenen Lage abweicht. Werden Halbleiterscheiben mit einheitlicher Dicke und möglichst ebenen Seitenflächen angestrebt, verläuft ein idealer Schnittspalt geradlinig und rechtwinkelig zur Längsachse des Werkstücks. Mit anderen Worten ausgedrückt, die Trajektorie durch die Mitte eines solchen Schnittspalts läuft entlang einer Gerade, die senkrecht zur Längsachse des Werkstücks orientiert ist. Eine solche Trajektorie wird nachfolgend als anzustrebende Trajektorie bezeichnet. Demnach liegt eine Fehllage eines Schnittspalts vor, wenn die tatsächliche Trajektorie von der anzustrebenden Trajektorie abweicht. Das ist dann der Fall, wenn ein Ortsvektor, der zur Mitte des Schnittspalts zeigt, nicht mehr auf der anzustrebenden Trajektorie endet.

Eine Fehllage eines Schnittspalts entsteht beispielsweise, wenn sich ein Draht während des Eingriffs in das Werkstück senkrecht zu seiner Laufrichtung, also in Richtung der Drehachsen der Drahtführungsrollen bewegt, zwischen denen er gespannt ist, oder wenn sich das Werkstück während des Zustellens durch die Anordnung von Drähten auf Grund von Wärmeentwicklung axial ausdehnt. Die Fehllage eines Schnittspalts ist im zuletzt genannten Fall umso größer, je mehr Abstand der Schnittspalt zur Mitte des Werkstücks hat. Die Mitte des Werkstücks ist der Ort zwischen den beiden Enden des Werkstücks.

Ein Aspekt der vorliegenden Erfindung ist, die Fehllage der Schnittspalte zu ermitteln, unabhängig davon, welche Ursache zu einer Relativbewegung zwischen Werkstück und Drähten geführt hat. Beispiele für solche Ursachen sind eine Bewegung der Drähte, eine Bewegung des Werkstücks oder eine thermische Ausdehnung des Werkstücks. Ein weiterer Aspekt der vorliegenden Erfindung ist, zu unterscheiden zwischen einer Fehllage der Schnittspalte, die systematisch bei Verwendung einer bestimmten Drahtsäge auftritt, und einer Fehllage der Schnittspalte, die zufällig und unabhängig von der Verwendung einer bestimmten Drahtsäge auftritt.

Zweckmäßigerweise wird mindestens ein geschlossener Regelkreis eingerichtet, in dem auf eine Regelabweichung, also auf eine ermittelte Fehllage der Schnittspalte, mit einer Veränderung der Stellgröße, also dem Herbeiführen der Ausgleichsbewegung des Werkstücks reagiert wird.

Gemäß einer ersten Ausgestaltung der Erfindung erfolgt das Ermitteln der Fehllage der Schnittspalte während des Zustellens des Werkstücks durch die Anordnung von Drähten. Es wird die Position vorzugsweise eines jeden der Schnittspalte relativ zu einem feststehenden Bezugspunkt gemessen und mit einer Soll-Position verglichen. Die Soll-Position eines Schnittspalts ist die Position relativ zum feststehenden Bezugspunkt, die Voraussetzung wäre, damit ein idealer Schnittspalt entstehen kann. Die Abweichung der gemessenen Position des Schnittspalts von dessen Soll-Position entspricht der Fehllage des Schnittspalts. Da die Abweichung für jeden Schnittspalt grundsätzlich unterschiedlich ist, werden die Abweichungen zu einer Fehllage der Schnittspalte gemittelt. Mit anderen Worten, jedem Schnittspalt wird die gleiche Fehllage zugeordnet. Die Mittelung kann ohne Gewichtung erfolgen oder Fehllagen bestimmter Schnittspalte werden besonders gewichtet. Aus der Fehllage der Schnittspalte lässt sich ein Korrekturprofil ableiten, das vorgibt, mit welchem Betrag und in welche Richtung das Werkstück während des Zustellens des Werkstücks bewegt werden muss, um die Fehllage der Schnittspalte zu beseitigen. Das Korrekturprofil hat, betrachtet über die Eindringtiefe der Drähte in das Werkstück, einen Verlauf, der komplementär zum Verlauf der ermittelten Fehllage der Schnittspalte ist.

Das Messen der Position der Schnittspalte relativ zum feststehenden Bezugspunkt erfolgt vorzugsweise mittels Bestrahlung der Schnittspalte mit optischer Strahlung, IR-Strahlung, Röntgenstrahlung oder γ-Strahlung vorsieht. Darüber hinaus kommt auch eine mechanische Abtastung der Schnittspalte oder eine induktive oder kapazitive Messung der Schnittspalte in Betracht. Eine solche direkte Beobachtung der Schnittspalte legt jede Relativbewegung zwischen dem Werkstück und den Drähten offen.

In Abhängigkeit der ermittelten Fehllage der Schnittspalte wird während des Zustellens des Werkstücks eine Ausgleichsbewegung des Werkstücks entlang von dessen Längsachse herbeigeführt, die der ermittelten Fehllage entgegengerichtet ist. Die Fehllage der Schnittspalte wird also während des Zustellens des Werkstücks laufend reduziert und bestenfalls aufgehoben.

Gemäß einer zweiten Ausgestaltung der Erfindung erfolgt das Ermitteln der Fehllage der Schnittspalte vor dem Zustellen des Werkstücks durch die Anordnung von Drähten. Aufgrund dieser Vorgehensweise wird eine Fehllage der Schnittspalte ermittelt, die systematisch bei Verwendung einer bestimmten Drahtsäge auftritt. Zum Ermitteln der Fehllage der Schnittspalte wird die lokale Geometrie von Halbleiterscheiben, die zuvor mittels einer bestimmten Drahtsäge hergestellt wurden, gemessen. Diese Halbleiterscheiben stammen von einem oder mehreren Werkstücken, die mittels dieser Drahtsäge hergestellt wurden. Die lokale Geometrie einer Halbleiterscheibe bildet näherungsweise die Trajektorie des der Halbleiterscheibe benachbarten Schnittspalts ab. Vorzugsweise wird die lokale Geometrie von der Medianfläche einer warp-Messung nach SEMI MF 1390-0218 abgeleitet und zwar wie folgt: eine Höhenlinie (line scan, LS) wird erzeugt durch Selektion derjenigen Messwerte der Medianfläche, welche sich auf einer Linie befinden, die durch das Zentrum der Halbleiterscheibe verläuft. Die Messwerte liegen auf einer Linie, die einem Durchmesser der Halbleiterscheibe vorzugsweise in Richtung des Zustellens des Werkstücks beim Abtrennen der Halbleiterscheibe folgt oder zumindest um nicht mehr als ± 20° von einer solchen Richtung abweicht.

Um eine Fehllage der Schnittspalte zu erkennen, die systematisch beim Verwenden einer bestimmten Drahtsäge auftritt, wird die lokale Geometrie der Halbleiterscheiben, die von einem oder mehreren Werkstücken, die mittels dieser Drahtsäge hergestellt wurden, zu einer einzigen lokalen Geometrie gemittelt. Die Mittelung kann ohne Gewichtung erfolgen oder die lokale Geometrie bestimmter Halbleiterscheiben wird auf Grund von deren relativen Lage im Werkstück besonders gewichtet. Beispielsweise kann bei der Mittelung die lokale Geometrie nur solcher Halbleiterscheiben berücksichtigt werden, die aus dem Bereich der Mitte oder dem Bereich einer der Enden eines oder mehrerer zuvor bearbeiteter Werkstücke hervorgingen. Ausgehend von der gemittelten lokalen Geometrie wird dann geschlossen, wie die Trajektorie der Schnittspalte sein wird, falls die bestimmte Drahtsäge verwendet wird und weitere Einflüsse, die sich auf die Trajektorie auswirken, außer Betracht bleiben. Eine solche Trajektorie wird nachfolgend zu erwartende Trajektorie genannt. Die Fehllage der Schnittspalte, mit der während des Zustellens des Werkstücks zu rechnen ist, ergibt sich aus dem Vergleich der zu erwartenden Trajektorie mit der anzustrebenden Trajektorie. Der Vergleich liefert ein drahtsägespezifisches Korrekturprofil, das Richtung und Betrag der Ausgleichsbewegung des Werkstücks in Abhängigkeit der Eindringtiefe der Drähte in das Werkstück während des Zustellens des Werkstücks durch die Anordnung von Drähten vorgibt. Der Verlauf des drahtsägespezifischen Korrekturprofils ist im Prinzip komplementär zum Verlauf der gemittelten lokalen Geometrie.

Das drahtsägespezifische Korrekturprofil wird vorzugsweise zusätzlich herangezogen, um frühzeitig Veränderungen des Leistungsverhaltens der Drahtsäge erkennen und darauf reagieren zu können. Veränderungen des drahtsägespezifischen Korrekturprofils, die im Verlauf der Bearbeitung von Werkstücken auftreten, weisen auf einen Verschleiß des Drahts und/oder des Belags der Drahtführungsrollen oder eines anderen, einem Verschleiß unterworfenen Bauteils der Drahtsäge hin. Es kann deshalb eine Schwelle für die Veränderung des drahtsägespezifischen Korrekturprofils definiert werden, bei deren Erreichen vorsorgliche Wartungsmaßnahmen (predictive maintenance) eingeleitet werden. Auch vor dem Erreichen einer solchen Schwelle können Veränderungen des drahtsägespezifischen Korrekturprofils zu Anlass genommen werden, um Anpassungsmaßnahmen vorzunehmen, die einer verschleißbedingten Verschlechterung des Arbeitsergebnisses entgegenwirken. Solche Anpassungsmaßnahmen können beispielsweise die Änderung der Zusammensetzung und/oder der Temperatur einer Schneidmittel-Suspension oder die Änderung der Temperatur eines Kühlmittels beinhalten, ebenso wie die Änderung der Drahtgeschwindigkeit oder anderer prozessspezifischer Parameter.

Eine dritte Ausgestaltung der Erfindung sieht vor, die erste und die zweite Ausgestaltung zu kombinieren. Ein erster Teil der Ausgleichsbewegung des Werkstücks wird auf der Grundlage eines Korrekturprofils herbeigeführt, das entsprechend der ersten Ausgestaltung der Erfindung in Echtzeit während des Zustellens des Werkstücks in Abhängigkeit der Eindringtiefe der Drähte ermittelt wird. Ein weiterer Teil der Ausgleichsbewegung des Werkstücks wird auf der Grundlage eines drahtsägespezifischen Korrekturprofils herbeigeführt, das entsprechend der zweiten Ausgestaltung der Erfindung vor dem Zustellen des Werkstücks durch die Anordnung von Drähten ermittelt wurde. Damit werden Einflüsse auf die Fehllage der Schnittspalte, die zufällig auftreten und deshalb nicht vorhersehbar sind, und solche, die wegen der Verwendung einer bestimmten Drahtsäge systematisch auftreten, voneinander entkoppelt berücksichtigt.

Ein drahtsägespezifisches Korrekturprofil kann selbstverständlich auch durch Aufzeichnen des Korrekturprofils erhalten werden, das gemäß der ersten Ausgestaltung des erfindungsgemäßen Verfahrens abgeleitet wird.

Die vorliegende Erfindung kann in Verbindung mit Drähten genutzt werden, die am Draht gebundenes Schneidkorn aufweisen, oder in Verbindung mit Drähten, die frei davon sind und ihre Wirkung in Kombination mit einer Schneidmittel-Suspension entfalten. Als gebundenes Schneidkorn kommt insbesondere Diamant in Frage. Die Drähte, von denen hier die Rede ist, sind Abschnitte eines Drahts, der um die Drahtführungsrollen der Drahtsäge gewickelt ist. Die Anzahl der Drahtführungsrollen der Drahtsäge ist nicht wesentlich für die Nutzung der Erfindung. Beispielsweise kann die Drahtsäge zwei, drei, vier oder eine noch höhere Anzahl von Drahtführungsrollen umfassen.

Das Werkstück besteht vorzugsweise aus einem Halbleitermaterial wie Silizium, das in multikristallinem oder einkristallinem Zustand vorliegen kann. Der Umfang des Werkstücks ist quadratisch, rechteckig oder kreisförmig. Das erfindungsgemäße Verfahren eignet sich insbesondere zur Herstellung von runden Halbleiterscheiben aus einkristallinem Silizium mit einem Durchmesser von mindestens 200 mm, insbesondere mindestens 300 mm.

Die Erfindung wird nachfolgend unter Bezugnahme auf Zeichnungen weiter erläutert.

### Kurzbeschreibung der Figuren

**Fig.1** zeigt Merkmale einer Drahtsäge, die zur Durchführung des erfindungsgemäßen Verfahrens geeignet ist.
**Fig.2** zeigt, wie sich eine tatsächliche Trajektorie durch die Mitte eines Schnittspalts von einer anzustrebenden Trajektorie unterscheiden kann.
**Fig.3** zeigt ein Korrekturprofil.
**Fig.4** bis **Fig.6** und **Fig.7** bis **Fig.9** zeigen von Medianflächen einer warp-Messung abgeleitete Höhenlinien von jeweils drei Halbleiterscheiben.
**Fig.10** bis **Fig.12** entsprechen **Fig.4** bis **Fig.6** mit dem Unterschied einer höher aufgelösten Skalierung der Ordinate.
Die **Fig.13, Fig.14** und **Fig.15** zeigen, wie sich ein drahtsägespezifisches Korrekturprofil im Verlauf der Bearbeitung von mehreren Werkstücken verändern kann.

### Liste der verwendeten Bezugszeichen

- **1**: Sägedraht
- **2**: Rillen
- **3**: linke Drahtführungsrolle
- **4**: rechte Drahtführungsrolle
- **5**: Achse
- **6**: Achse
- **7**: Rotation
- **8**: Drehrichtung
- **9**: Drahtlängsbewegung
- **10**: Drahtlängsbewegung
- **11**: Drahtgatter
- **12**: Zustelleinrichtung
- **13**: Schnittspalt
- **14**: Achse
- **15**: Werkstück
- **16**: Sägeleiste
- **17**: Kleber
- **18**: Pfeilrichtung
- **19**: Düsenkamm
- **20**: Düsenkamm
- **21**: Düsen
- **22**: Strahl
- **23**: Strahl
- **24**: anzustrebende Trajektorie

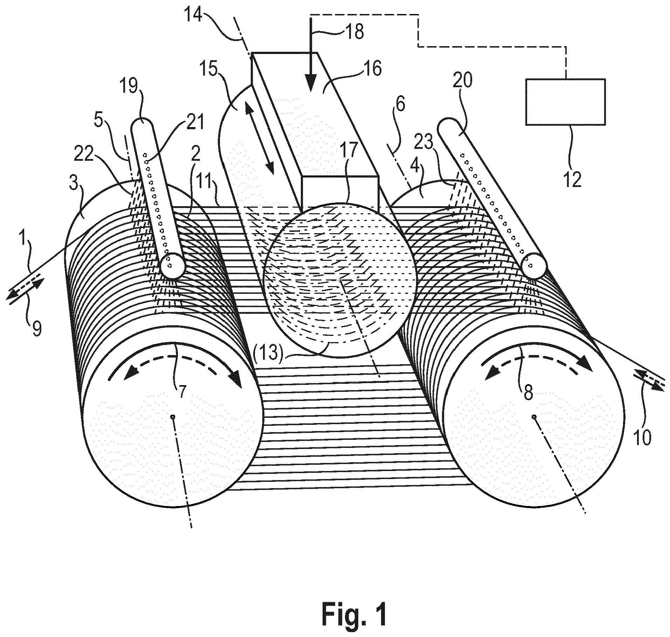

Fig.1 zeigt Merkmale einer Drahtsäge, die zur Durchführung des erfindungsgemäßen Verfahrens geeignet ist. Die Drahtsäge umfasst Sägedraht 1, der mehrfach spiralförmig um eine linke Drahtführungsrolle 3 und eine rechte Drahtführungsrolle 4 umgelegt und von Rillen 2 so geführt wird, dass die auf der Oberseite der Drahtführungsrollen verlaufenden Drahtabschnitte, die zur Beschreibung der vorliegenden Erfindung als Drähte bezeichnet werden, parallel verlaufen und ein Drahtgatter 11 bilden. Ein Werkstück 15 ist an einer Sägeleiste 16 befestigt, beispielsweise mittels eines Klebers 17 geklebt. Die Sägeleiste 16 wird mit dem Werkstück 15 von einer andeutungsweise dargestellten Zustelleinrichtung 12 in Pfeilrichtung 18 senkrecht gegen das Drahtgatter 11 zugestellt und mit den Drähten des Gatters 11 in Eingriff gebracht. Gegebenenfalls umfasst die Drahtsäge linke Düsenkämme 19 und rechte Düsenkämme 20 mit Düsen 21 zum Zuführen einer Schneidmittel-Suspension in Form eines linken länglichen Strahls 22 und eines rechten länglichen Strahls 23 auf die linke Drahtführungsrolle 3 und die rechte Drahtführungsrolle 4.

Die Drahtführungsrollen sind um Achsen 5 und 6 drehbar gelagert. Ihre Achsen und die Achse 14 des Werkstücks 15 - im gezeigten Beispiel ein zylindrischer Stab - sind parallel zueinander ausgerichtet. Zum Einleiten des Trennvorgangs wird eine Drahtführungsrolle, beispielsweise die linke Drahtführungsrolle 3, zur Rotation 7 angetrieben ("Master"). Die andere Drahtführungsrolle("Slave"), im Beispiel die rechte Drahtführungsrolle 4, dreht sich, durch Draht 1 gezogen, gleichsinnig in Drehrichtung 8 mit. Beim Eingreifen der Drähte in das Werkstück 15 bilden sich Schnittspalte 13.

Üblicherweise wird die Richtung der Drahtlängsbewegung 9, 10 mehrfach während eines vollständigen Schnitts durch das Werkstück 15 umgekehrt (gestrichelte Pfeile), wobei in jedem einzelnen dieser "Pilgerschritt" genannten Paare aus Richtungsumkehrungen der Draht um eine größere Länge in die eine und eine kleinere Länge in die entgegengesetzte Richtung bewegt wird.

Erfindungsgemäß ist vorgesehen, nach dem Ermitteln der Fehllage der Schnittspalte eine Ausgleichsbewegung des Werkstücks 15 in Abhängigkeit der ermittelten Fehllage entlang der Achse 14 des Werkstücks 15 herbeizuführen und zwar basierend auf einem Korrekturprofil und/oder einem drahtsägespezifischen Korrekturprofil, abgeleitet vom der ermittelten Fehllage der Schnittspalte. Der Doppelpfeil repräsentiert die Ausgleichsbewegung des Werkstücks 15, die durch die Zustelleinrichtung 12 veranlasst wird.

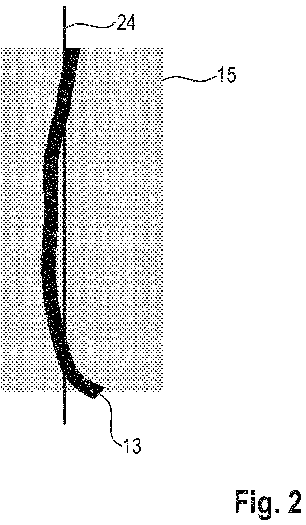

Fig.2 zeigt im Querschnitt ein Bild, das sich durch Beobachten der Schnittspalte während des Eingriffs der Drähte in das Werkstück gewinnen lässt. Es zeigt einen Teil des Werkstücks 15 und einen Schnittspalt 13, der sich durch das Werkstück erstreckt. Die tatsächliche Trajektorie, die durch die Mitte des Schnittspalts 13 verläuft, weicht während des Entstehens des Schnittspalts mehr oder weniger deutlich von einer anzustrebenden Trajektorie 24 ab. Die Differenz repräsentiert die ermittelte Fehllage des Schnittspalts 13. Wie erwähnt, sieht die Erfindung vor, eine Ausgleichsbewegung des Werkstücks in Abhängigkeit der ermittelten Fehllage der Schnittspalte entlang einer Längsachse des Werkstücks herbeizuführen.

Der Vergleich von tatsächlicher Trajektorie und anzustrebender Trajektorie gemäß der ersten Ausgestaltung der Erfindung beziehungsweise der Vergleich von zu erwartender Trajektorie und anzustrebender Trajektorie gemäß der zweiten Ausgestaltung der Erfindung führt zu einer Beschreibung des Verlaufs der Fehllage der Schnittspalte in Abhängigkeit der Eindringtiefe der Drähte im Werkstück und zu einem Korrekturprofil (erste Ausgestaltung der Erfindung) beziehungsweise zu einem drahtsägespezifischen Korrekturprofil (zweite Ausgestaltung der Erfindung), die jeweils komplementär zum Verlauf der Fehllage der Schnittspalte sind.

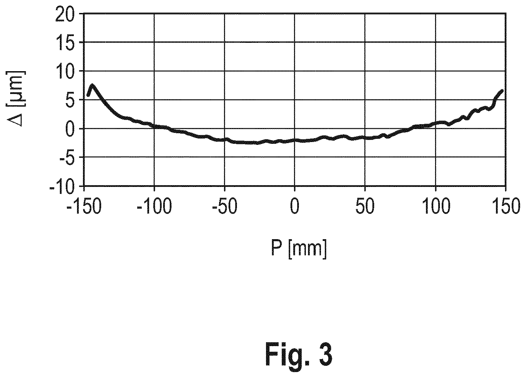

Fig.3 zeigt ein Korrekturprofil, in dem die Abweichung Δ der tatsächlichen Trajektorie von der anzustrebenden Trajektorie in Abhängigkeit der Eindringtiefe P der Drähte aufgetragen ist. Eine Ausgleichsbewegung des Werkstücks mit einer Richtung und einem Betrag, der der Abweichung Δ entspricht, wird mittels der Zustelleinrichtung herbeigeführt. Nur wenn keine Fehllage der Schnittspalte vorliegt (Δ = 0), was im gezeigten Beispiel zunächst ungefähr bei einer Eindringtiefe von -90 mm der Fall ist, unterbleibt das Herbeiführen der Ausgleichsbewegung des Werkstücks.

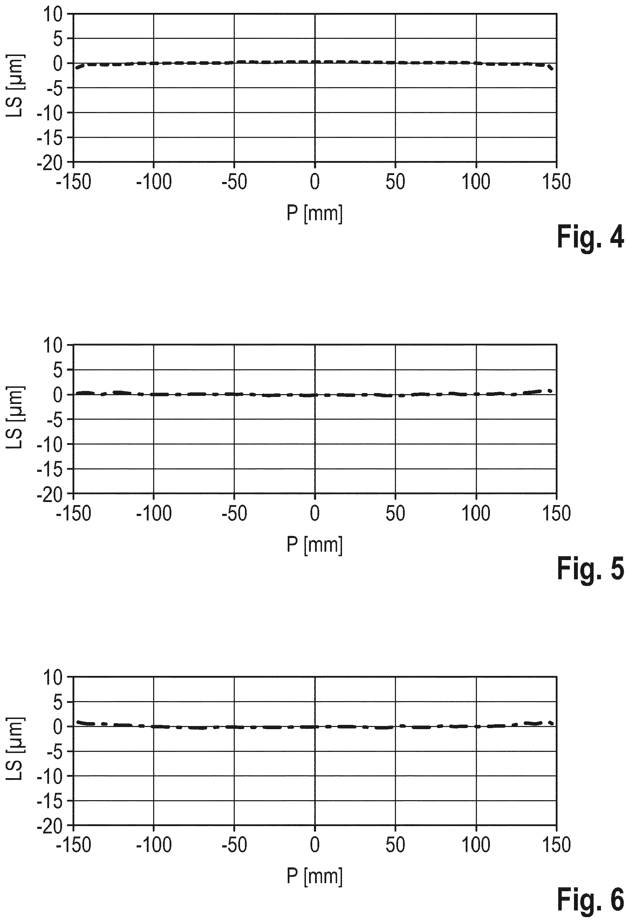

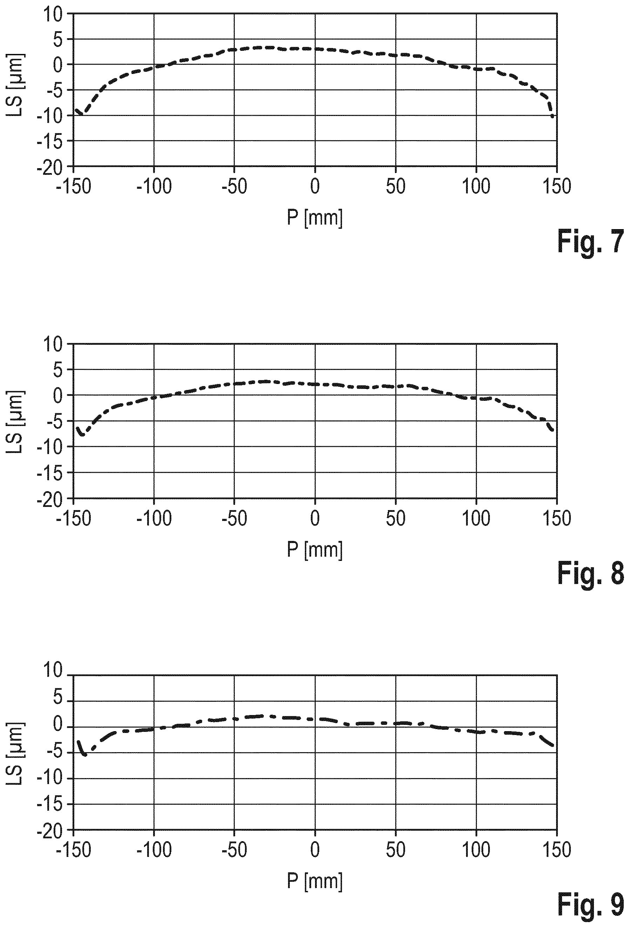

Fig.4 bis Fig.9 zeigen Höhenlinien LS von jeweils drei Halbleiterscheiben, die durch Drähte eines Drahtgatters von einem Werkstück abgetrennt wurden, wobei während des Abtrennens der Halbleiterscheiben eine vom Korrekturprofil vorgegebene Ausgleichsbewegung des Werkstücks herbeigeführt wurde (Fig.4 bis Fig.6) oder auf das Herbeiführen einer solchen Ausgleichsbewegung verzichtet wurde (Fig.7 bis Fig.9). Die Höhenlinien sind jeweils von der Medianfläche einer warp-Messung abgeleitet, wobei Messwerte der Medianfläche selektiert wurden, die auf einer Linie liegen, die dem Durchmesser der jeweiligen Halbleiterscheibe in Richtung des Werkstücks beim Abtrennen der Halbleiterscheibe folgt. Die Position der Halbleiterscheiben im Werkstück war so, dass beim Abtrennen der Halbleiterscheiben zwischen jeder der drei Halbleiterscheiben 50 weitere Halbleiterscheiben entstanden.

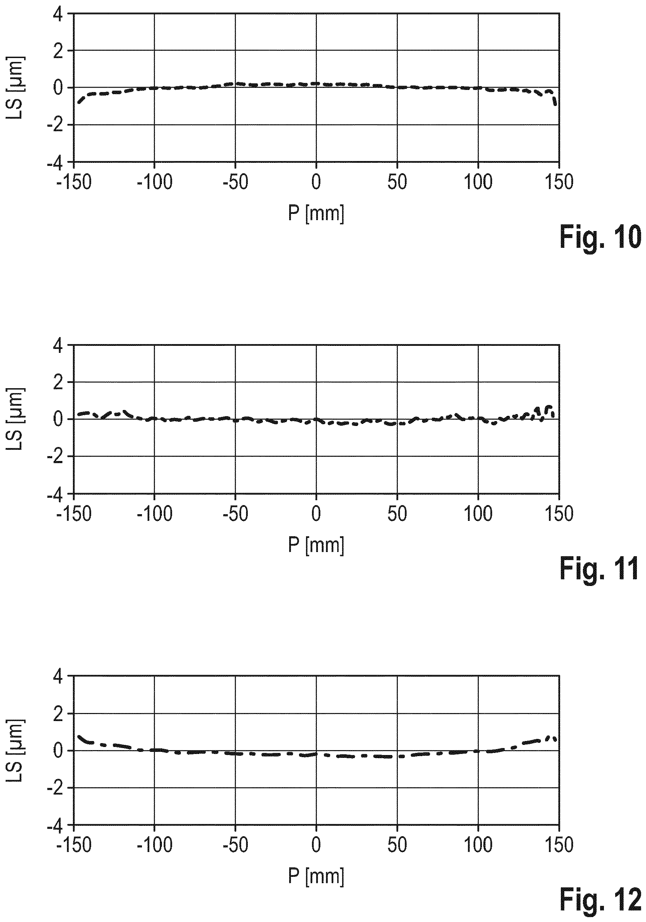

Wie der Vergleich der Höhenlinien offenlegt, werden Halbleiterscheiben durch Anwendung der Erfindung deutlich ebener und zwar ohne besonderen Einfluss von deren Position im Werkstück. Das bestätigen auch Fig. 10 bis Fig.12, die sich von Fig.4 bis Fig.6 nur dadurch unterscheiden, dass bei ihnen die Skalierung der Ordinate höher aufgelöst ist.

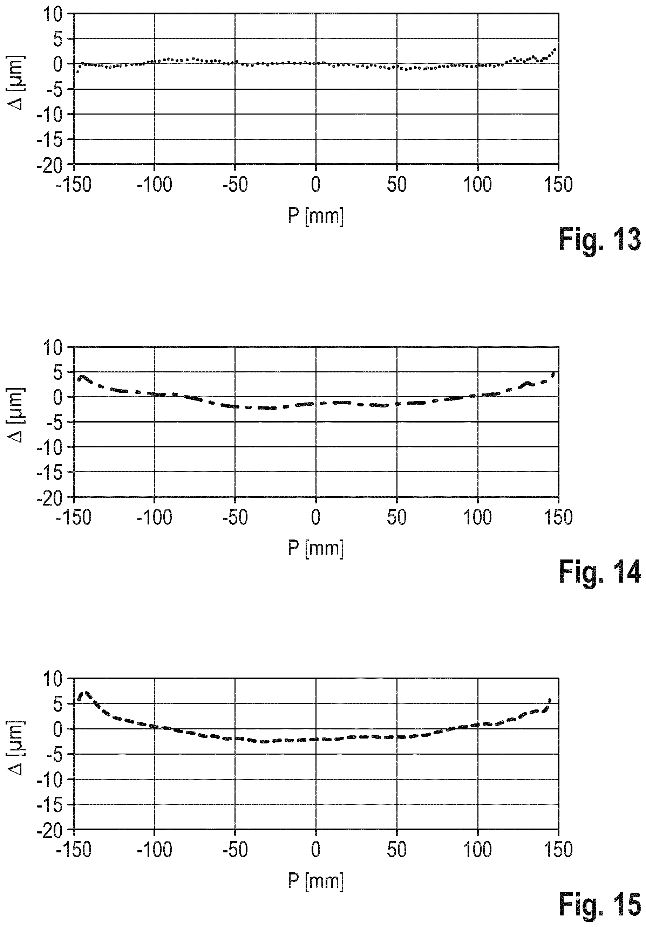

Fig.13, 14 und 15 zeigen, wie sich ein drahtsägespezifisches Korrekturprofil im Verlauf der Bearbeitung von mehreren Werkstücken stetig verändern kann. Es ist deshalb vorteilhaft, eine Schwelle für die Abweichung Δ zu definieren, bei deren Überschreiten vorsorgliche Wartungsmaßnahmen eingeleitet werden. Die Schwelle kann beispielsweise so definiert sein, dass erst ein drahtsägespezifisches Korrekturprofil mit einer maximale Abweichung Aₘₐₓ, wie sie in Fig.15 dargestellt ist, zur Folge hat, dass vorsorgliche Wartungsmaßnahmen eingeleitet werden.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

## Patentansprüche

1. Verfahren zur Herstellung von Halbleiterscheiben aus einem Werkstück durch Bearbeiten des Werkstücks mittels einer Drahtsäge, umfassend das Zustellen des Werkstücks durch eine Anordnung von Drähten, die zwischen Drahtführungsrollen gespannt sind und sich in eine Laufrichtung bewegen; und das Erzeugen von Schnittspalten beim Eingriff der Drähte in das Werkstück; **dadurch gekennzeichnet, dass** das Verfahren umfasst: das Ermitteln einer Fehllage der Schnittspalte; und das Herbeiführen einer Ausgleichsbewegung des Werkstücks in Abhängigkeit der ermittelten Fehllage entlang einer Längsachse des Werkstücks während des Zustellens des Werkstücks durch die Anordnung von Drähten.

2. Verfahren nach Anspruch 1, umfassend das Ermitteln der Fehllage der Schnittspalte während des Zustellens des Werkstücks durch die Anordnung von Drähten.

3. Verfahren nach Anspruch 1 oder Anspruch 2, umfassend das Ermitteln der Fehllage der Schnittspalte durch Messen der Position der Schnittspalte mittels Bestrahlung der Schnittspalte mit optischer Strahlung, IR-Strahlung, Röntgenstrahlung oder γ-Strahlung, durch mechanisches Abtasten der Schnittspalte oder durch induktive oder kapazitive Messung der Schnittspalte, und Vergleichen der gemessenen Position mit einer Soll-Position der Schnittspalte.

4. Verfahren nach einem der Ansprüche 1 bis 3, umfassend das Verfolgen von Veränderungen eines drahtsägespezifischen Korrekturprofils im Verlauf der Bearbeitung mehrerer Werkstücke und das Einleiten einer vorsorglichen Wartungsmaßnahme, falls die Veränderungen eine festgelegte Schwelle erreicht haben.

5. Verfahren nach Anspruch 4, umfassend das Ermitteln der Fehllage der Schnittspalte durch Messen der lokalen Geometrie von Halbleiterscheiben, die zuvor mittels der Drahtsäge hergestellt wurden, zum Erstellen des drahtsägespezifischen Korrekturprofils.

## Claims

1. A method for producing semiconductor wafers from a workpiece by means of machining of the workpiece by means of a wire saw, comprising feeding the workpiece through an arrangement of wires tensioned between wire guide rollers and move in a running direction Z; and the creation of kerfs when engaging the wires into the workpiece;
**characterized in that** the method comprises:
Determining a placement error of the kerfs; and bringing about a compensating movement of the workpiece as a function of the detected placement error along a longitudinal axis of the workpiece during infeed of the workpiece by the arrangement of wires.

2. The method as claimed in claim 1, comprising determining the placement error of the kerfs during the feeding of the workpiece due to the arrangement of wires.

3. A method as claimed in to claim 1 or claim 2, comprising determining the Placement error of the kerf by measuring the position of the kerf by irradiating the kerf with optical radiation, IR radiation,
X-radiation or y-radiation, by mechanical scanning of the kerf
or by inductive or capacitive measurement of the kerf, and comparing the measured position with a nominal position of the kerf.

4. A method as claimed in one of claims 1 to 3, comprising tracking changes of a wire saw specific correction profile in the course of the processing of several workpieces and the initiation of a precautionary maintenance action if the changes have reached a specified threshold.

5. The method as claimed in claim 4, comprising determining the placement error of the kerfs by measuring the local geometry of semiconductor wafers previously produced by the wire saw to create the wire saw specific correction profile.

## Revendications

1. Procédé de fabrication de plaquettes semi-conductrices à partir d'une pièce à usiner par usinage de la pièce au moyen d'une scie à fil, comprenant
l'avance de la pièce par un ensemble de fils tendus entre des galets de guidage de fils et se déplaçant dans une direction de marche Z ; et la création de fentes de coupe lors de l'engagement des fils dans la pièce à usiner ;
**caractérisé en ce que** le procédé comprend :
Détermination d'une position erronée de la colonne de coupe ; et la réalisation d'un mouvement de compensation de la pièce à usiner en fonction de la position incorrecte déterminée le long d'un axe longitudinal de la pièce à usiner pendant l' avance de la pièce à usiner par l'agencement de fils métalliques.

2. Procédé selon la revendication 1, comprenant la détermination de la position erronée de la interstices de coupe pendant l'avance de la pièce grâce à l'agencement de fils de fer.

3. Procédé selon la revendication 1 ou la revendication 2, comprenant la détermination de la mauvaise position de la fente de coupe en mesurant la position de la fente de oupe au moyen d'une irradiation de la fente de coupe avec un rayonnement optique, un rayonnement IR, des rayons X ou des rayons y, par balayage mécanique des fentes de coupe ou par mesure inductive ou capacitive des fentes de coupe, et comparaison de la position mesurée avec une position de consigne des fentes de coupe.

4. Procédé selon l'une quelconque des revendications 1 à 3, comprenant le suivi de Modifications d'un profil de correction spécifique à la scie à fil au cours du l'usinage de plusieurs pièces et le lancement d'une procédure de précaution Intervention de maintenance si les modifications ont atteint un seuil défini.

5. Procédé selon la revendication 4, comprenant la détermination de la position erronée de des interstices de coupe en mesurant la géométrie locale des plaquettes semi-conductrices préalablement fabriquées à l'aide de la scie à fil, afin de créer le profil de correction spécifique à la scie à fil.
